(19) 

Europäisches
Patentamt

European
Patent Office

Office européen
des brevets

(11) **EP 4 739 073 A1**

(12) **EUROPEAN PATENT APPLICATION**

(43) Date of publication:
**06.05.2026 Bulletin 2026/19**

(21) Application number: **25210804.8**

(22) Date of filing: **23.10.2025**

(51) International Patent Classification (IPC):
***H10W 70/685*** (2026.01)   ***H10W 40/25*** (2026.01)
***H10W 42/00*** (2026.01)

(52) Cooperative Patent Classification (CPC):
**H10W 70/685;** H10W 40/259; H10W 42/101;
H10W 70/686

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **29.10.2024 US 202463713081 P**

(71) Applicant: **Absolics Inc.**
**Covington, GA 30014 (US)**

(72) Inventors:
• **KIM, Sungjin**
**Covington, Georgia, 30014 (US)**
• **KIM, Jincheol**
**18469 Hwaseong-si, Gyeonggi-do (KR)**

(74) Representative: **BCKIP Part mbB**
**MK1**
**Landsbergerstraße 98, 3.Stock**
**80339 München (DE)**

(54) **PACKAGING SUBSTRATE AND SEMICONDUCTOR PACKAGE COMPRISING THE SAME**

(57)    A packaging substrate according to the present disclosure comprises a core layer and an insulating layer disposed on the core layer. The insulating layer comprises an insulating resin. The insulating layer comprises a first insulating layer and a second insulating layer disposed on the first insulating layer. A hydroxyl peak intensity of the second insulating layer measured by FT-IR is smaller than a hydroxyl peak intensity of the first insulating layer measured by FT-IR. A moisture absorption amount of the packaging substrate measured after being left to stand for 7 days under an atmosphere of 23 °C and 50 % RH is 500 ppm to 1200 ppm.

In such a case, a packaging substrate and the like capable of stably maintaining long-term durability and electrical reliability may be provided.

EP 4 739 073 A1

**Description**

This application claims the priority benefit of US provisional Application No. 63/713,081 filed on October 29, 2024.

**TECHNICAL FIELD**

The present disclosure relates to a packaging substrate and a semiconductor package comprising the same.

**BACKGROUND**

In manufacturing an electronic component, a process of implementing a circuit on a semiconductor wafer is called a front-end process (FE: Front-End), and assembling the wafer into a state usable in an actual product is called a back-end process (BE: Back-End), which includes a packaging process.

Among the four core technologies that have enabled rapid advancement of the semiconductor industry-which drives the development of electronic devices-are semiconductor technology, semiconductor packaging technology, manufacturing process technology, and software technology. Although semiconductor technology has advanced in various forms, such as linewidths in the submicron to nanometer range, integration of tens of millions of cells, high-speed operation, and high heat dissipation, the technology for perfectly packaging such semiconductors has not been sufficiently established. Accordingly, the electrical performance of a semiconductor may be determined not only by the semiconductor technology itself but also by the packaging technology and the electrical connection associated therewith.

As materials for a packaging substrate, ceramics or resins are generally used. In the case of a ceramic substrate, due to its high resistance or high dielectric constant, it is difficult to mount a high-performance, high-frequency semiconductor device thereon. In the case of a resin substrate, although it is relatively capable of mounting a high-performance, high-frequency semiconductor device, there is a limitation in reducing wiring pitch.

Recently, research has been conducted on applying silicon or glass as materials for high-end packaging substrates. By forming through holes in a silicon or glass substrate and applying a conductive material to the through holes, wiring length between a device and a motherboard can be shortened, thereby achieving excellent electrical characteristics.

**SUMMARY**

A packaging substrate according to one embodiment of the present disclosure comprises a core layer and an insulating layer disposed on the core layer.

The insulating layer comprises an insulating resin.

The insulating layer comprises a first insulating layer and a second insulating layer disposed on the first insulating layer.

A hydroxyl peak intensity of the second insulating layer measured by FT-IR is smaller than a hydroxyl peak intensity of the first insulating layer measured by FT-IR.

A moisture absorption amount of the packaging substrate measured after being left to stand for 7 days under an atmosphere of 23 °C and 50 % RH is 500 ppm to 1200 ppm.

A hydroxyl group reduction ratio (Rhd value) of the packaging substrate represented by the following Formula 1 may be 30 % to 80 %.

[Formula 1]

$$Rhd = \frac{H1 - H2}{H1} \times 100(\%)$$

In Formula 1, H1 is a hydroxyl peak intensity of the first insulating layer measured by FT-IR, and H2 is a hydroxyl peak intensity of the second insulating layer measured by FT-IR.

A modulus of elasticity of the insulating layer measured at 23 °C may be 4 GPa to 8 GPa.

The insulating layer may be disposed in contact with at least a portion of an upper surface of the core layer.

A peel strength of the insulating layer with respect to the upper surface of the core layer measured by a 90° peeling test may be 25 N/cm$^2$ or more.

A shear strength of the insulating layer with respect to the upper surface of the core layer may be 40 N/cm$^2$ or more.

The insulating resin may comprise an epoxy-based resin.

The core layer may comprise a glass core or a ceramic core.

A semiconductor package according to another embodiment of the present disclosure comprises the packaging substrate and a device electrically connected to the packaging substrate.

**BRIEF DESCRIPTION OF THE DRAWINGS**

FIG. 1 is a cross-sectional view illustrating a packaging substrate according to one embodiment of the present disclosure.

FIG. 2 is a cross-sectional view illustrating a packaging substrate according to another embodiment of the present disclosure.

**DETAILED DESCRIPTION**

Hereinafter, exemplary embodiments of the present disclosure will be described in detail with reference to the accompanying drawings so that those skilled in the art to which the present disclosure pertains can easily carry out the present disclosure. However, the present disclosure may be embodied in various different forms, and is not limited to the embodiments described herein. Throughout the entire specification, the same reference numerals are assigned to similar parts.

Throughout the present specification, the term "combination thereof" included in Markush-type expressions means one or mixture or combination selected from a group consisting of components listed in the Markush-type expression, and refers to one or more selected from the group consisting of the components.

In the present specification, terms such as "first," "second," or "A," "B," and the like are used to distinguish between identical terms. Also, unless clearly indicated otherwise in the context, singular expressions include plural expressions.

In the present specification, the term "~-based" may mean that a compound corresponding to "~" and/or a compound derived from "~" is included in the compound.

In the present specification, when it is stated that "B is disposed on A," it means that B is directly disposed on A or disposed on A with another layer interposed therebetween, and it is not to be interpreted as being limited to a case in which B is in direct contact with a surface of A.

In the present specification, when it is stated that "B is connected to A," it means that A and B are directly connected or connected through another component interposed therebetween, and unless otherwise stated, it is not to be interpreted as being limited to a case in which A and B are directly connected.

In the present specification, unless otherwise specified, singular expressions are interpreted to include both singular and plural meanings as understood from the context.

In the drawings of the present specification, the shape, relative size, and angle of each element may be exaggerated or schematically shown for the purpose of description, and the scope of rights is not to be construed as being limited to the drawings.

In the present specification, when it is stated that A and B are "adjacent," it means that A and B are located in contact with each other or near each other without being in contact. Unless otherwise specified, the expression that A and B are adjacent is not to be interpreted as being limited to a case in which A and B are in contact with each other.

In the present specification, unless otherwise specified, the term "fine line" refers to a line having a width of 5 $\mu$m or less, or, for example, refers to a line having a width of 1 $\mu$m to 4 $\mu$m or less.

Unless otherwise specified in this specification, physical property values of each component in the packaging substrate are interpreted as values measured at room temperature. Room temperature refers to 20 °C to 25 °C.

In the present specification, a peak intensity measured by FT-IR (Fourier-transform infrared spectroscopy) refers to the height of a peak based on absorbance.

Packaging Substrate

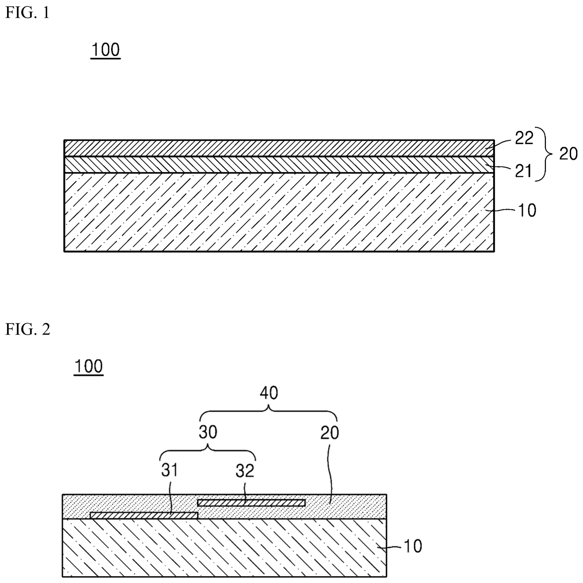

FIG. 1 is a cross-sectional view illustrating a packaging substrate according to one embodiment of the present disclosure. Hereinafter, the present disclosure will be described with reference to FIG. 1.

Hereinafter, embodiments will be described in detail.

A packaging substrate 100 according to one embodiment of the present disclosure comprises a core layer 10 and an insulating layer 20 disposed on the core layer 10.

The core layer 10 has a substrate shape and may function as a support layer in the packaging substrate 100. The core layer 10 may be a glass core or a ceramic core. In this case, lower moisture absorbability may be exhibited as compared with a packaging substrate to which an organic substrate is applied.

The core layer 10 may be a glass core. As examples, alkali borosilicate plate glass, alkali-free borosilicate plate glass, and alkali-free alkaline earth borosilicate plate glass may be applied, and plate glass applied as an electronic component may be applied. Glass substrates for electronic devices may be applied as the glass core, and, by way of example, those manufactured by SCHOTT, AGC, or Coming may be applied; however, the present disclosure is not limited thereto.

The core layer 10 may include a through via (not shown) penetrating in a thickness direction of the core layer 10.

The through via is constituted by an internal space (not shown) and a via inner surface (not shown) surrounding the internal space. The internal space means a void space, and the via inner surface means a surface of the core layer 10 formed on an inner side of the through via.

The through via may have a diameter that varies in the thickness direction of the core layer 10. The through via may have a substantially uniform diameter in the thickness direction of the core layer 10.

A surface of the core layer 10 may include an upper surface and a side surface connected to the upper surface and formed in the thickness direction of the core layer 10. The surface of the core layer 10 may include a lower surface facing the upper surface.

That the side surface is formed in the thickness direction of the core layer 10 is interpreted to mean not only that the side surface forms a perpendicular with the upper surface of the core layer 10, but also that at least a portion of the side surface forms an angle other than 90 degrees (an inclination angle) with the upper surface.

The side surface may be a plane, and may be a curved surface.

The core layer 10 may include a cavity (not shown) which is a space formed by an inward recess.

The cavity may be formed such that a portion on the upper-surface side and/or the lower-surface side of the core layer 10 is recessed in the thickness direction of the core layer 10, or may be formed to penetrate in the thickness direction of the core layer 10.

A device may be mounted in the cavity, and the packaging substrate 100 and the device may be electrically connected. The device may be not only a semiconductor device such as a CPU, a GPU, or a memory chip, but also a capacitor device, a transistor device, an impedance device, or other modules. That is, as long as it is a semiconductor device mounted in a semiconductor apparatus, it may be applied without limitation as the device.

A thickness of the core layer 10 may be 100 $\mu$m to 1,000 $\mu$m. The thickness may be 200 $\mu$m or more. The thickness may be 300 $\mu$m or more. The thickness may be 900 $\mu$m or less. The thickness may be 800 $\mu$m or less. The thickness may be 700 $\mu$m or less. When such a core layer 10 is applied to the packaging substrate 100 together with the insulating layer 20 to be described below, the packaging substrate 100 may have a thinner thickness while having stable durability.

The packaging substrate 100 may comprise an insulating layer 20 disposed on the core layer 10. The insulating layer 20 may be disposed in contact with at least a portion of an upper surface of the core layer 10.

The insulating layer 20 may comprise an insulating resin. The insulating resin may impart insulating characteristics to the insulating layer 20.

The insulating layer 20 may comprise a first insulating layer 21 and a second insulating layer 22 disposed on the first insulating layer 21. The second insulating layer 22 may be disposed in contact with an upper surface of the first insulating layer 21. Another component may be disposed between the first insulating layer 21 and the second insulating layer 22 so that the second insulating layer 22 is disposed spaced apart from the first insulating layer 21.

When the second insulating layer 22 is disposed in contact with the upper surface of the first insulating layer 21, when observed in a cross-section in the thickness direction of the packaging substrate 100, an interface between the first insulating layer 21 and the second insulating layer 22 may be observed through a microscope or the like, and the interface may not be observed.

When the second insulating layer 22 is disposed in contact with the upper surface of the first insulating layer 21 and the interface between the first insulating layer 21 and the second insulating layer 22 is not observed, the first insulating layer 21 and the second insulating layer 22 are distinguished based on a hydroxyl peak intensity measured by FT-IR.

A hydroxyl peak intensity of the second insulating layer 22 measured by FT-IR is smaller than a hydroxyl peak intensity of the first insulating layer 21 measured by FT-IR.

A hydroxyl peak measured by FT-IR may be observed at a wavenumber of 3400 cm$^{-1}$ to 3650 cm$^{-1}$.

The present disclosure may control a content ratio of hydroxyl groups of the first insulating layer 21 and the second insulating layer 22. Specifically, by allowing the second insulating layer 22, whose upper surface is exposed during a manufacturing or transfer process, to have a relatively lower hydroxyl group content than the first insulating layer 21, deterioration in durability of the insulating layer 20 due to moisture absorption may be effectively suppressed.

The hydroxyl peak intensities of the first insulating layer 21 and the second insulating layer 22 measured by FT-IR are measured with an FT-IR spectrophotometer equipped with an ATR device. By way of example, a Spotlight 400 model of PerkinElmer may be applied as the FT-IR spectrophotometer.

A hydroxyl group reduction ratio (Rhd value) of the packaging substrate 100 represented by the following Formula 1 may be 30 % to 80 %.

[Formula 1]

$$Rhd = \frac{H1 - H2}{H1} \times 100(\%)$$

In the Formula 1, H1 is a hydroxyl peak intensity of the first insulating layer 21 measured by FT-IR, and H2 is a hydroxyl peak intensity of the second insulating layer 22 measured by FT-IR.

The hydroxyl peak intensity is a peak height based on absorbance.

The present disclosure may allow the packaging substrate 100 to have a controlled Rhd value so that the insulating layer 20 has excellent moisture resistance, and cracking in the insulating layer 20 is suppressed by preventing brittleness of the insulating layer 20 from becoming excessively high.

The Rhd value of the packaging substrate 100 may be 30 % to 80 %. The Rhd value may be 40 % or more. The Rhd value may be 50 % or more. The Rhd value may be 55 % or more. The Rhd value may be 75 % or less. In such a case, both moisture resistance and flexibility of the insulating layer 20 may be improved together.

A moisture absorption amount of the packaging substrate 100 measured after being left to stand for 7 days under an atmosphere of 23 °C and 50 % RH may be 100 ppm to 1000 ppm.

When the insulating layer 20 is excessively exposed to moisture, phenomena such as hydrolysis of the insulating resin due to moisture and reduction in bonding strength between the core layer 10 and the insulating layer 20 may occur, which may become a major cause of degradation in long-term durability and electrical reliability of the packaging substrate 100. The present disclosure may suppress deterioration of the insulating layer 20 caused by moisture by controlling a moisture absorption amount of the packaging substrate 100 to a certain level or less.

The moisture absorption amount of the packaging substrate 100 may be measured as follows.

The packaging substrate 100 is left to stand for 7 days under an atmosphere of 23 °C and 50 % RH, and the packaging substrate 100 is cut in the thickness direction to prepare a sample having a mass of 5 g.

Subsequently, Karl Fischer reagent is introduced into a Karl Fischer moisture meter, nitrogen gas is supplied at a flow rate of 200 ml/min, and an internal temperature of the Karl Fischer moisture meter is set to 120 °C. Without introducing the sample into the Karl Fischer moisture meter, the mass of moisture is measured under the conditions of back purge for 10 minutes, cell purge for 10 minutes, and measurement time of 20 minutes. Then, the sample is introduced into the Karl Fischer moisture meter, and the mass of moisture is measured under the same conditions of back purge for 10 minutes, cell purge for 10 minutes, and measurement time of 20 minutes. A value obtained by subtracting the mass of moisture measured without the sample from the mass of moisture measured with the sample introduced is defined as the moisture absorption amount of the packaging substrate 100.

By way of example, the Karl Fischer moisture meter may be an MKS-710S model of KEM.

A moisture absorption amount of the packaging substrate 100 measured after being left to stand for 7 days under an atmosphere of 23 °C and 50 % RH may be 500 ppm to 1200 ppm. The moisture absorption amount may be 550 ppm or more. The moisture absorption amount may be 600 ppm or more. The moisture absorption amount may be 1150 ppm or less. The moisture absorption amount may be 1100 ppm or less. In such a case, appropriate flexibility may be imparted to the insulating layer 20 while reducing damage to the insulating layer 20 caused by hydrolysis.

A modulus of elasticity of the insulating layer 20 measured at 23 °C may be 8 GPa or less. The modulus of elasticity may be 7.5 GPa or less. The modulus of elasticity may be 7 GPa or less. The modulus of elasticity may be 4 GPa or more. In such a case, occurrence of cracks within the insulating layer 20 after curing may be effectively suppressed.

The modulus of elasticity of the insulating layer 20 is measured in pull mode at 23 °C using a universal testing machine (UTM). During measurement, the tensile speed is 1 mm/min, and an average value of N = 5 is used as the measurement condition.

The present disclosure may improve long-term durability of the packaging substrate 100 by applying the insulating layer 20 having controlled properties such as the moisture absorption amount as described above to the packaging substrate 100 so that stable bonding strength is formed between the insulating layer 20 and the core layer 10 within the packaging substrate 100.

The insulating layer 20 may be disposed in contact with at least a portion of the upper surface of the core layer 10. A peel strength of the insulating layer 20 with respect to the upper surface of the core layer 10 measured by a 90° peeling test may be 25 N/cm$^2$ or more. The peel strength may be 27 N/cm$^2$ or more. The peel strength may be 29 N/cm$^2$ or more. The peel strength may be 32 N/cm$^2$ or more. The peel strength may be 34 N/cm$^2$ or more. The peel strength may be 50 N/cm$^2$ or less.

A shear strength of the insulating layer 20 with respect to the upper surface of the core layer 10 may be 40 N/cm$^2$

or more. The shear strength may be 45 N/cm$^2$ or more. The shear strength may be 50 N/cm$^2$ or more. The shear strength may be 55 N/cm$^2$ or more. The shear strength may be 80 N/cm$^2$ or less.

In such a case, delamination of the insulating layer 20 caused by long-term use of the packaging substrate 100 may be substantially suppressed.

The peel strength may be measured within an area of 1 cm × 1 cm in the substrate 100 using a universal testing machine (UTM) with a 500 N load cell. During the peeling of the insulating layer 20, the insulating layer 20 is peeled from the upper surface 11 of the glass core at an angle of 90°, and a peeling speed is set to 10 mm/min. When measuring the peel strength, the ambient temperature is set to 23 °C, and the ambient humidity is set to 50 % RH.

The shear strength may be measured within an area of 1 cm × 1 cm in the substrate 100 using a universal testing machine (UTM) with a 1 kN load cell. A load is applied to the insulating layer 20 in an in-plane direction of the substrate 100 at a speed of 5 mm/min within the area until the insulating layer 20 is separated, and the maximum load until separation is defined as the shear strength. When measuring the shear strength, the ambient temperature is set to 23 °C, and the ambient humidity is set to 50 % RH.

During the measurements of peel strength and shear strength, an area in which the insulating layer 20 is in contact with the upper surface of the core layer 10 is set as a measurement target.

By way of example, the universal testing machine may be a 5969 UTM model manufactured by Instron.

The insulating layer 20 may comprise an insulating resin. The insulating resin may comprise an epoxy-based resin. The insulating resin may comprise a cured epoxy-based resin.

The insulating resin may comprise 70 wt% or more of an epoxy-based resin. The insulating resin may comprise 80 wt% or more of an epoxy-based resin. The insulating resin may comprise 90 wt% or more of an epoxy-based resin. The insulating resin may comprise 100 wt% or less of an epoxy-based resin.

The epoxy-based resin may comprise a first residue derived from a bisphenol-type epoxy resin and/or a second residue derived from a novolac-type epoxy resin. The epoxy-based resin may comprise a bisphenol-type epoxy resin and/or a novolac-type epoxy resin.

The bisphenol-type epoxy resin may comprise at least one selected from a bisphenol A-type epoxy resin or a bisphenol F-type epoxy resin. The bisphenol-type epoxy resin may be a bisphenol A-type epoxy resin.

The novolac-type epoxy resin may comprise at least one selected from a phenol-novolac-type epoxy resin or a cresol-novolac-type epoxy resin.

The epoxy-based resin may comprise 50 wt% or more of the first residue. The epoxy-based resin may comprise 60 wt% or more of the first residue. The epoxy-based resin may comprise 90 wt% or less of the first residue. In such a case, excellent mechanical strength may be imparted to the insulating layer 20.

The epoxy-based resin may comprise 5 wt% or more of the second residue. The epoxy-based resin may comprise 10 wt% or more of the second residue. The epoxy-based resin may comprise 15 wt% or more of the second residue. The epoxy-based resin may comprise 40 wt% or less of the second residue. The epoxy-based resin may comprise 35 wt% or less of the second residue. The epoxy-based resin may comprise 30 wt% or less of the second residue.

The insulating layer 20 may comprise 50 wt% or more of an epoxy-based resin. The insulating layer 20 may comprise 55 wt% or more of an epoxy-based resin. The insulating layer 20 may comprise 60 wt% or more of an epoxy-based resin. The insulating layer 20 may comprise 65 wt% or more of an epoxy-based resin. The insulating layer 20 may comprise 100 wt% or less of an epoxy-based resin. The insulating layer 20 may comprise 95 wt% or less of an epoxy-based resin. The insulating layer 20 may comprise 90 wt% or less of an epoxy-based resin. In such a case, during the manufacturing process of the packaging substrate 100, excessive thermal expansion of the insulating layer 20 may be suppressed while providing stable insulating characteristics to an area where a conductive layer is disposed.

The insulating layer 20 may comprise a filler. The filler may help the insulating layer 20 have controlled thermal expansion characteristics.

The filler is not limited as long as it can be generally applied in the field of packaging substrates. For example, the filler may be any one selected from the group consisting of silica, barium sulfate, magnesium carbonate, calcium carbonate, aluminum oxide, aluminum hydroxide, aluminum nitride, titanium oxide, and combinations thereof.

The insulating layer 20 may comprise 12 wt% or more of the filler. The insulating layer 20 may comprise 15 wt% or more of the filler. The insulating layer 20 may comprise 30 wt% or less of the filler.

The insulating layer 20 may further comprise other additives in addition to the components described above. The additives are not limited as long as they are those generally applied in the field of packaging substrates. Examples of the additives may include a curing agent, a colorant, and a defoaming agent.

FIG. 2 is a cross-sectional view illustrating a packaging substrate according to another embodiment of the present disclosure. The present disclosure will be described below with reference to FIG. 2.

The packaging substrate 100 comprises a core layer 10 and an insulating layer 20 disposed on the core layer 10. The configurations of the components of the packaging substrate 100 are the same as those described with reference to FIG. 1 above. The following description focuses on the different parts.

The packaging substrate 100 may comprise a first redistribution layer 40 disposed on the core layer 10. The first redistribution layer 40 may comprise a conductive layer 30 and the insulating layer 20 surrounding at least a portion of the conductive layer 30.

The conductive layer 30 is a wiring that transmits an electrical signal. The conductive layer 30 may comprise an electrically conductive material. For example, the conductive layer 30 may comprise at least one selected from copper, nickel, aluminum, gold, or silver. Copper or the like may be applied as a material of the conductive layer 30.

A description of the physical properties and composition of the insulating layer 20 will be omitted because it overlaps with the foregoing description.

The first redistribution layer 40 may be disposed in contact with the upper surface of the core layer 10. Another component may be disposed between the first redistribution layer 40 and the upper surface of the core layer 10.

The insulating layer 20 and the conductive layer 30 may be disposed together in the first redistribution layer 40. The first redistribution layer 40 may be formed such that the conductive layer 30 having a predetermined position and shape is embedded in the insulating layer 20. At least a portion of the conductive layer 30 in the first redistribution layer 40 may be formed as a fine line. The first redistribution layer 40 may be electrically connected to a terminal or device positioned on an upper portion of the packaging substrate 100.

The conductive layer 30 may comprise a first conductive layer 31 disposed in contact with the upper surface of the core layer 10. The insulating layer 20 may surround a portion of the first conductive layer 31. The insulating layer 20 may surround at least a portion of an upper surface of the first conductive layer 31. The insulating layer 20 may surround at least a portion of a side surface of the first conductive layer 31.

The conductive layer 30 may comprise a second conductive layer 32 disposed on the core layer 10 without being in contact with the core layer 10. The insulating layer 20 may surround at least a portion of the second conductive layer 32. The insulating layer 20 may surround the entirety of the second conductive layer 32.

A peel strength of the conductive layer 30 with respect to the upper surface of the insulating layer 20 may be 3 N/cm or more. The peel strength may be 3.5 N/cm or more. The peel strength may be 4 N/cm or more. The peel strength may be 10 N/cm or less. In such a case, the insulating layer 20 may stably support, protect, and insulate the conductive layer 30.

The peel strength of the conductive layer 30 with respect to the insulating layer 20 is measured by a bond tester according to a 180° peel test. The measurement speed (peeling speed) is 10 mm/s, the measurement distance (peeling distance) is 70 mm, and the measurement area is set to a region of the upper or lower surface of the core layer 10 in which no through via is formed. For example, the peel strength value may be measured using a Condor Sigma bond tester manufactured by XYZ TEC. The packaging substrate 100 may further comprise a second redistribution layer (not shown) disposed below the core layer 10.

The second redistribution layer may comprise a conductive layer and an insulating layer surrounding at least a portion of the conductive layer. A description of the conductive layer and the insulating layer is omitted because it overlaps with the foregoing description.

The insulating layer and the conductive layer may be disposed together in the second redistribution layer. The second redistribution layer may be formed such that a conductive layer having a predetermined position and shape is embedded in the insulating layer. The second redistribution layer may be electrically connected to a terminal or a main board positioned below the packaging substrate 100.

A ratio of a thickness of the first redistribution layer 40 to a thickness of the core layer 10 may be 0.2 to 1.5. The ratio may be 0.3 or more. The ratio may be 0.4 or more. The ratio may be 1.2 or less. The ratio may be 1 or less. A ratio of a sum of thicknesses of the first redistribution layer and the second redistribution layer to a thickness of the core layer 10 may be 0.4 to 3. The ratio may be 0.6 or more. The ratio may be 0.8 or more. The ratio may be 2.4 or less. The ratio may be 2 or less. In such a case, the surface area of the insulating layer exposed to the outside may be controlled, thereby contributing to suppression of moisture absorption of the packaging substrate.

The packaging substrate 100 may further comprise bumps (not shown) disposed below the second redistribution layer.

The bumps may be disposed in predetermined shapes below the core layer 10. For example, the bumps may be disposed on a lower surface of the packaging substrate 100 so as to be in contact with a main board or the like.

Semiconductor Package

A semiconductor package according to another embodiment of the present disclosure comprises a packaging substrate and a device electrically connected to the packaging substrate.

The packaging substrate may be mounted on a main board and may be electrically connected to the main board.

A description of the packaging substrate and the device is omitted because it overlaps with the foregoing description.

Method for Manufacturing Packaging Substrate

A method for manufacturing a packaging substrate according to another embodiment of the present disclosure comprises a preparation step of providing a pre-oxidation substrate comprising a core layer and a first insulating layer disposed on the core layer, and an oxidation treatment step of oxidizing an upper side of the first insulating layer to form a second insulating layer, thereby manufacturing the packaging substrate.

In the preparation step, a pre-oxidation substrate in which a first insulating layer is already formed on the core layer may be introduced, or the pre-oxidation substrate may be prepared by forming a first insulating layer on the core layer.

The core layer may be the same as the core layer described above. A description of the core layer is omitted because it overlaps with the foregoing description.

If necessary, a core layer on which a conductive layer is formed on an upper surface may be prepared.

The first insulating layer may be prepared by laminating an insulating layer-forming film on the core layer and then curing the film, or by coating an insulating layer-forming composition on the core layer and then curing the compostion.

The insulating layer-forming composition (or film) before curing may comprise an epoxy resin and a curing agent. The insulating layer-forming composition (or film) may further comprise a filler.

The epoxy resin may comprise a bisphenol-type epoxy resin and/or a novolac-type epoxy resin. The bisphenol-type epoxy resin may comprise at least one selected from a bisphenol A-type epoxy resin or a bisphenol F-type epoxy resin. The bisphenol-type epoxy resin may be a bisphenol A-type epoxy resin. The novolac-type epoxy resin may comprise at least one selected from a phenol-novolac-type epoxy resin or a cresol-novolac-type epoxy resin.

The epoxy resin may comprise 50 wt% or more of a bisphenol-type epoxy resin. The epoxy resin may comprise 60 wt% or more of a bisphenol-type epoxy resin. The epoxy resin may comprise 90 wt% or less of a bisphenol-type epoxy resin.

The epoxy resin may comprise 5 wt% or more of a novolac-type epoxy resin. The epoxy resin may comprise 10 wt% or more of a novolac-type epoxy resin. The epoxy resin may comprise 15 wt% or more of a novolac-type epoxy resin. The epoxy resin may comprise 40 wt% or less of a novolac-type epoxy resin. The epoxy resin may comprise 35 wt% or less of a novolac-type epoxy resin. The epoxy resin may comprise 30 wt% or less of a novolac-type epoxy resin.

The insulating layer-forming composition (or film) may comprise 50 wt% or more of an epoxy resin. The insulating layer-forming composition (or film) may comprise 55 wt% or more of an epoxy resin. The insulating layer-forming composition (or film) may comprise 60 wt% or more of an epoxy resin. The insulating layer-forming composition (or film) may comprise 65 wt% or less of an epoxy resin. The insulating layer-forming composition (or film) may comprise 100 wt% or less of an epoxy resin. The insulating layer-forming composition (or film) may comprise 95 wt% or less of an epoxy resin. The insulating layer-forming composition (or film) may comprise 90 wt% or less of an epoxy resin.

The insulating layer-forming composition (or film) may further comprise a curing agent. The curing agent may form a cured epoxy-based resin through a crosslinking reaction with the epoxy resin. The curing agent is not limited as long as it is one generally applicable to epoxy resins.

The insulating layer-forming composition (or film) may further comprise a filler. As the filler, the same filler described above may be applied. A description of the filler is omitted because it overlaps with the foregoing description.

The insulating layer-forming composition (or film) may comprise 12 wt% or more of a filler. The insulating layer-forming composition (or film) may comprise 15 wt% or more of a filler. The insulating layer-forming composition (or film) may comprise 30 wt% or less of a filler.

The insulating layer-forming composition (or film) may further comprise additives generally applied in the field of build-up films. Examples of the additives may include a curing agent, a colorant, and a defoaming agent.

Immediately after forming the insulating layer-forming composition (or film) on the core layer, the composition (or film) may be subjected to preliminary heat treatment to partially cure the composition (or film). During the preliminary heat treatment, a heat treatment temperature may be 40 °C or higher. The heat treatment temperature may be 50 °C or higher. The heat treatment temperature may be 100 °C or lower. The heat treatment temperature may be 90 °C or lower. The heat treatment time during the preliminary heat treatment may be 1 minute or longer. The heat treatment time may be 3 minutes or longer. The heat treatment time may be 5 minutes or longer. The heat treatment time may be 30 minutes or shorter. The heat treatment time may be 20 minutes or shorter.

The insulating layer-forming composition (or film) formed on the core layer may be cured to form the first insulating layer. The insulating layer-forming composition (or film) may be disposed in contact with at least a portion of an upper surface of the core layer. The insulating layer-forming composition (or film) may be disposed in contact with at least a portion of an upper surface of a conductive layer disposed on the core layer.

The curing may be performed in two or more processes comprising a first curing process and a second curing process.

In the first curing process, the insulating layer-forming composition (or film) formed on the upper surface of the core layer may be heat-treated.

A heat treatment temperature of the first curing process may be 40 °C or higher. The heat treatment temperature may be 50 °C or higher. The heat treatment temperature may be 100 °C or lower. The heat treatment temperature may be 90 °C or lower.

A heat treatment time of the first curing process may be 30 minutes or longer. The heat treatment time may be 40 minutes or longer. The heat treatment time may be 3 hours or shorter. The heat treatment time may be 2 hours or shorter.

In the second curing process, the insulating layer-forming composition (or film) having undergone the first curing process may be heat-treated to form a preliminary insulating layer. A heat treatment temperature of the second curing process may be 100 °C or higher. The heat treatment temperature may be 120 °C or higher. The heat treatment temperature may be 250 °C or lower. The heat treatment temperature may be 200 °C or lower.

A heat treatment time of the second curing process may be 45 minutes or longer. The heat treatment time may be 1 hour or longer. The heat treatment time may be 5 hours or shorter. The heat treatment time may be 3 hours or shorter.

In the oxidation treatment step, the upper side of the first insulating layer may be oxidized to form the second insulating layer. Specifically, light having a controlled wavelength may be irradiated onto the upper surface of the first insulating layer. In this case, a photo-oxidation reaction may proceed on the upper surface side of the first insulating layer, thereby forming, on the first insulating layer, a second insulating layer having a controlled hydroxyl group content. A remaining portion of the insulating layer, except for the portion in which the second insulating layer is formed, may still constitute the first insulating layer.

In the oxidation treatment step, light having a wavelength of 200 nm to 300 nm may be irradiated. The wavelength may be 230 nm to 270 nm.

In the oxidation treatment step, a luminous intensity of light irradiated on the upper surface of the preliminary insulating layer may be 30 mW/cm$^2$ or more. The luminous intensity may be 50 mW/cm$^2$ or more. The luminous intensity may be 70 mW/cm$^2$ or more. The luminous intensity may be 200 mW/cm$^2$ or less. The luminous intensity may be 150 mW/cm$^2$ or less.

In the oxidation treatment step, a light irradiation time may be 10 minutes to 40 minutes. The light irradiation time may be 15 minutes or more. The light irradiation time may be 35 minutes or less.

In such a case, the hydroxyl group distribution in the insulating layer may be reduced while preventing excessive curing of the second insulating layer.

If necessary, after forming the conductive layer on the formed insulating layer, another insulating layer may be formed on the conductive layer to surround the conductive layer, thereby forming the first redistribution layer.

The conductive layer and the first redistribution layer may be the same as the conductive layer and the first redistribution layer described above. A description of the conductive layer and the first redistribution layer is omitted because it overlaps with the foregoing description.

The conductive layer may be formed by a dry method or a wet method.

The dry method is a method in which a seed layer is formed by sputtering on a region where the conductive layer is to be disposed, and the conductive layer is formed by plating a metal on the region in which the seed layer has been formed. When forming the seed layer, metals such as titanium, chromium, or nickel may be sputtered, or those metals may be sputtered together with copper. Through sputtering, an anchor effect in which metal particles interact with the surface of the core layer or the insulating layer may occur, thereby improving adhesion of the conductive layer.

The wet method is a method in which a primer is applied to a region where formation of the conductive layer is required, followed by metal plating. The primer may comprise a compound having a functional group such as an amine. Depending on a desired degree of adhesion, the primer may comprise both a compound having a functional group such as an amine and a silane coupling agent. When a silane coupling agent is applied, the surface to be treated may be pretreated with the silane coupling agent, and then a primer layer may be formed by coating the pretreated region with a compound having an amine group.

After forming the seed layer or the primer layer, a metal may be plated to form the conductive layer. Copper plating may be applied when forming the conductive layer; however, the present disclosure is not limited thereto. Before metal plating, a region in the seed layer or the primer layer where formation of the conductive layer is unnecessary may be deactivated, or a region where formation of the conductive layer is necessary may be activated, and then plating may be performed. The activation or deactivation process may be performed by light irradiation treatment such as irradiating a laser having a specific wavelength, or by chemical treatment. However, without applying the activation or deactivation treatment, metal plating may be performed, and thereafter, the conductive layer may be patterned by etching according to a predetermined design.

After forming the conductive layer, an insulating layer surrounding the conductive layer may be formed. The insulating layer formed on the conductive layer may be formed by the same method as described above.

If necessary, the second redistribution layer may be formed below the core layer using the same method applied to form the first redistribution layer.

The method for manufacturing the packaging substrate according to the present disclosure may further comprise a process of forming connection a terminal, a bump, or a cover layer on an upper surface and/or a lower surface of the packaging substrate, or a process of mounting a device on the substrate.

Hereinafter, the present disclosure will be described in more detail through specific examples. The following examples are merely provided to assist in understanding the present disclosure, and the scope of the present disclosure is not limited thereto.

**Preparation Example: Manufacturing of Packaging Substrate**

Example 1: As a liquid epoxy resin, 80 g of bisphenol A-type epoxy resin, 20 g of novolac-type epoxy resin, and 30 g of polyamine curing agent were mixed under vacuum using a stirrer at a speed of 200 rpm for 30 minutes. Then, 30 g of a filler (12 g of silica, 8 g of alumina, and 10 g of an organic silicone filler) was added to the mixed composition, and additional mixing was performed at a speed of 150 rpm for 10 minutes. The composition containing the filler was degassed for 20 minutes to prepare an insulating layer-forming composition.

The insulating layer-forming composition was coated on an upper surface of a glass core, which served as the core layer, having a size of 100 mm × 100 mm, to a thickness of 5 $\mu$m, and the coated composition was heat-treated at 60 °C for 10 minutes to form an insulating layer-forming composition layer.

By the same method as described above, six layers of the insulating layer-forming composition layer were formed on the upper side of the core layer, and three layers were formed below the core layer.

Subsequently, the substrate having the insulating layer-forming composition layers formed on both upper and lower surfaces of the core layer was placed in a heat treatment chamber, heat-treated at 60 °C for 1 hour, and additionally heat-treated at 150 °C for 2 hours to form a preliminary insulating layer. After the heat treatment was completed, the packaging substrate was completed by cooling the atmosphere temperature to 25 °C at a cooling rate of 0.5 °C/min.

Light having a wavelength of 254 nm was irradiated onto the upper surface of the preliminary insulating layer for 10 minutes to form an insulating layer comprising a first insulating layer and a second insulating layer, thereby completing the packaging substrate. During light irradiation, the luminous intensity of light irradiated on the upper surface of the preliminary insulating layer was 100 mW/cm$^2$.

Example 2: Except that the light irradiation time was 20 minutes, the packaging substrate was manufactured in the same manner as in Example 1.

Example 3: Except that the light irradiation time was 30 minutes, the packaging substrate was manufactured in the same manner as in Example 1.

Comparative Example 1: Except that no light irradiation was performed on the preliminary insulating layer, the packaging substrate was manufactured in the same manner as in Example 1.

Comparative Example 2: Except that the light irradiation time was 5 minutes, the packaging substrate was manufactured in the same manner as in Example 1.

Comparative Example 3: Except that the light irradiation time was 45 minutes, the packaging substrate was manufactured in the same manner as in Example 1.

Comparative Example 4: Except that the light irradiation time was 60 minutes, the packaging substrate was manufactured in the same manner as in Example 1.

Comparative Example 5: Except that the light irradiation time was 120 minutes, the packaging substrate was manufactured in the same manner as in Example 1.

**Evaluation Example: Measurement of Rhd Value**

During the manufacturing of the packaging substrates in each of the Examples and Comparative Examples, the hydroxyl peak intensity was measured on the upper surface of the first insulating layer before light irradiation using a Spotlight 400 FT-IR spectrophotometer manufactured by PerkinElmer, and the measured value was defined as H1.

Subsequently, light irradiation was performed on the first insulating layer to complete the second insulating layer, and the hydroxyl peak intensity was measured on the upper surface of the second insulating layer using the same spectrophotometer, and the measured value was defined as H2.

The Rhd value was calculated from the measured $H_1$ and $H_2$ values.

The measured values and calculated values for each of the Examples and Comparative Examples are shown in Table 1 below.

**Evaluation Example: Measurement of Moisture Absorption Amount**

Each of the packaging substrates of the Examples and Comparative Examples was left to stand for 7 days under an atmosphere of 23 °C and 50 % RH, and then cut in the thickness direction to prepare a sample having a total mass of 5 g.

Subsequently, Karl Fischer reagent was introduced into an MKS-710S Karl Fischer moisture meter manufactured by KEM, nitrogen gas was supplied at a flow rate of 200 ml/min, and the internal temperature of the Karl Fischer moisture meter was set to 120 °C. Without introducing the sample, the mass of moisture was measured under conditions of a back purge for 10 minutes, a cell purge for 10 minutes, and a measurement time of 20 minutes. Then, the sample was introduced, and the mass of moisture was measured again under conditions of a back purge for 10 minutes, a cell purge for 10 minutes, and a measurement time of 20 minutes. A value obtained by subtracting the moisture mass measured without the sample from the moisture mass measured with the sample was defined as the moisture absorption amount of the packaging substrate.

The calculated values for each of the Examples and Comparative Examples are shown in Table 1 below.

**Evaluation Example: Evaluation of Crack Generation**

The surface of the insulating layer of each packaging substrate in the Examples and Comparative Examples was observed using an optical microscope. When no defect such as cracks or bubbles was observed on the surface of the insulating layer, the result was evaluated as "Pass," and when such defects were observed, it was evaluated as "Fail."

The calculated values for each of the Examples and Comparative Examples are shown in Table 1 below.

**Evaluation Example: Evaluation of Delamination under High Temperature and High Humidity**

Each packaging substrate of the Examples and Comparative Examples was left to stand under an atmosphere of 85 °C and 85 % RH for 72 hours, and then whether the insulating layer was delaminated from the core layer was evaluated using an optical microscope. When the insulating layer was not delaminated, the result was evaluated as "Pass," and when delamination occurred, the result was evaluated as "Fail."

[Table 1]

|  | Rhd(%) | Moisture Absorption (ppm) | Crack Generation | Delamination |
|---|---|---|---|---|
| Example 1 | 40 | 998 | Pass | Pass |
| Example 2 | 60 | 721 | Pass | Pass |
| Example 3 | 65 | 598 | Pass | Pass |
| Comparative Example 1 | 0 | 2053 | Pass | Fail |
| Comparative Example 2 | 25 | 1244 | Pass | Fail |
| Comparative Example 3 | 70 | 485 | Fail | Pass |
| Comparative Example 4 | 75 | 420 | Fail | Fail |
| Comparative Example 5 | 80 | 392 | Fail | Fail |

As shown in Table 1, in the Examples in which the Rhd value was controlled within the range of 30 % to 80 %, all were evaluated as "Pass" in both the crack generation evaluation and the delamination evaluation, whereas in the Comparative Examples in which the Rhd value was outside the range defined in the present disclosure, at least one of the crack generation evaluation or the delamination evaluation was evaluated as "Fail."

Although the preferred embodiments of the present disclosure have been described in detail above, the scope of the present disclosure is not limited thereto, and various modifications and improvements made by those skilled in the art using the basic concepts defined in the following claims are also included within the scope of the present disclosure.

[Description of Reference Numerals]

100: packaging substrate
10: core layer
20: insulating layer
21: first insulating layer
22: second insulating layer
30: conductive layer
31: first conductive layer
32: second conductive layer
40: first redistribution layer

**Claims**

1.  A packaging substrate comprising:

    a core layer; and
    an insulating layer disposed on the core layer,
    wherein the insulating layer comprises an insulating resin,
    the insulating layer comprises a first insulating layer and a second insulating layer disposed on the first insulating layer,
    a hydroxyl peak intensity of the second insulating layer measured by FT-IR is smaller than a hydroxyl peak intensity of the first insulating layer measured by FT-IR, and
    a moisture absorption amount measured after being left to stand for 7 days under an atmosphere of 23 °C and 50 % RH is 500 ppm to 1200 ppm.

2.  The packaging substrate of claim 1,

    wherein a hydroxyl group reduction ratio (Rhd value) represented by the following Formula 1 is 30 % to 80 %:

    [Formula 1]

    $$Rhd = \frac{H1 - H2}{H1} \times 100(\%)$$

    in the Formula 1, wherein $H_1$ is a hydroxyl peak intensity of the first insulating layer measured by FT-IR, and $H_2$ is a hydroxyl peak intensity of the second insulating layer measured by FT-IR.

3.  The packaging substrate of claim 1,
    wherein a modulus of elasticity of the insulating layer measured at 23 °C is 4 GPa to 8 GPa.

4.  The packaging substrate of claim 1,

    wherein the insulating layer is disposed in contact with at least a portion of an upper surface of the core layer, and
    a peel strength of the insulating layer with respect to the upper surface of the core layer measured by a 90° peeling test is 25 N/cm$^2$ or more.

5.  The packaging substrate of claim 1,

    wherein the insulating layer is disposed in contact with at least a portion of an upper surface of the core layer, and
    a shear strength of the insulating layer with respect to the upper surface of the core layer is 40 N/cm$^2$ or more.

6.  The packaging substrate of claim 1,
    wherein the insulating resin comprises an epoxy-based resin.

7.  The packaging substrate of claim 1,
    wherein the core layer comprises a glass core or a ceramic core.

8.  A semiconductor package comprising:

    the packaging substrate of claim 1; and
    a device electrically connected to the packaging substrate.

FIG. 1

FIG. 2

Europäisches
Patentamt
European
Patent Office
Office européen
des brevets

## EUROPEAN SEARCH REPORT

**Application Number**

EP 25 21 0804

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/081862 A1 (HAYASHI TAKAHIRO [JP] ET AL) 4 April 2013 (2013-04-04) | 1,6-8 | INV. H10W70/685 |
| A | * paragraph [0012]; figure 2 * ----- | 2-5 | ADD. |
| A | "ENGINEERING DESIGN HANDBOOK DIELECTRIC EMBEDDING OF ELECTRICAL OR ELECTRONIC COMPONENTS", DARCOM PAMPHLET, No. 706-315, 6 April 1979 (1979-04-06), XP093363949, Retrieved from the Internet: URL:https://apps.dtic.mil/sti/pdfs/ADA07 4139.pdf * tables 6-2 * ----- | 1 | H10W40/25 H10W42/00 |
| A | LETTIERI MARIATERESA ET AL: "Effects of humid environment on thermal and mechanical properties of a cold-curing structural epoxy adhesive", CONSTRUCTION & BUILDING MATERIALS, vol. 30, 17 January 2012 (2012-01-17), pages 753-760, XP028896489, ISSN: 0950-0618, DOI: 10.1016/J.CONBUILDMAT.2011.12.077 * figure 2 * ----- | 1 | **TECHNICAL FIELDS SEARCHED (IPC)** H10W |

The present search report has been drawn up for all claims

| Place of search | Date of completion of the search | Examiner |
|---|---|---|
| The Hague | 9 February 2026 | Bürkle, Marius |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 21 0804

This annex lists the patent family members relating to the patent documents cited in the above-mentioned European search report.
The members are as contained in the European Patent Office EDP file on
The European Patent Office is in no way liable for these particulars which are merely given for the purpose of information.

09-02-2026

| Patent document cited in search report | Publication date | Patent family member(s) | | Publication date |
|---|---|---|---|---|
| US 2013081862 A1 | 04-04-2013 | JP | 2013093538 A | 16-05-2013 |
| | | KR | 20130036731 A | 12-04-2013 |
| | | TW | 201322837 A | 01-06-2013 |
| | | US | 2013081862 A1 | 04-04-2013 |

**EP 4 739 073 A1**

**Patent documents cited in the description**

- US 63713081